(19) Europäisches Patentamt
European Patent Office
Office européen des brevets

(11) **EP 4 653 900 A2**

(12) **EUROPEAN PATENT APPLICATION**

(43) Date of publication:
**26.11.2025 Bulletin 2025/48**

(21) Application number: **25208116.1**

(22) Date of filing: **10.10.2025**

(51) International Patent Classification (IPC):
***G01R 31/52*** (2020.01)        ***G01R 31/54*** (2020.01)

(52) Cooperative Patent Classification (CPC):
**G01R 31/52; G01R 31/54; H01M 10/425;**
G01R 31/392; G01R 31/396; G01R 31/66;
G01R 31/70; H01M 10/48

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **23.07.2025 CN 202511021167**

(71) Applicants:
• **JINKO SOLAR CO., LTD**
  **ShangRao, Jiangxi 334100 (CN)**

• **Zhejiang Jinko Energy Storage Co., Ltd.**
  **Jiaxing, Zhejiang 314415 (CN)**

(72) Inventors:
• **LEI, Kebing**
  **Shangrao, 334100 (CN)**
• **ZHANG, Luhua**
  **Shangrao, 334100 (CN)**
• **CAO, Baojian**
  **Shangrao, 334100 (CN)**

(74) Representative: **Haseltine Lake Kempner LLP**
**Cheapside House**
**138 Cheapside**
**London EC2V 6BJ (GB)**

(54) **FRACTURE DETECTION METHOD FOR CONNECTION COMPONENT OF ENERGY STORAGE SYSTEM, AND ENERGY STORAGE SYSTEM**

(57)    Disclosed are a fracture detection method for a connection component of an energy storage system, and an energy storage system. The method is applied to an energy storage edge and includes: obtaining operating state parameters of the at least one secondary battery sampled and uploaded by the sampling part; determining a parameter discrete characteristic value of the operating state parameters; performing a fracture detection for the connection component according to a magnitude relationship between the parameter discrete characteristic value and a preset discrete characteristic value threshold to obtain an edge-side fracture detection result; and sending the operating state parameters and the edge-side fracture detection result to an energy storage cloud for the energy storage cloud to generate a fracture detection result of the connection component according to a cloud-side fracture detection result and the edge-side fracture detection result.

```
┌─────────────────────────────────────────────────────────────┐
│ The operating state parameters of at least one secondary     │──  202
│ battery sampled and uploaded by the sampling part are        │
│ obtained.                                                     │
└─────────────────────────────────────────────────────────────┘
                              │
                              ▼
┌─────────────────────────────────────────────────────────────┐
│ A parameter discrete characteristic value of the operating   │──  204
│ state parameters is determined, and the parameter discrete   │
│ characteristic value characterizes a degree of dispersion of │
│ the operating state parameters of the at least one secondary │
│ battery.                                                      │
└─────────────────────────────────────────────────────────────┘
                              │
                              ▼
┌─────────────────────────────────────────────────────────────┐
│ The fracture detection for the connection component is       │──  206
│ performed according to the magnitude relationship between    │
│ the parameter discrete characteristic value and the preset   │
│ discrete characteristic value threshold, to obtain the       │
│ edge-side fracture detection result.                         │
└─────────────────────────────────────────────────────────────┘
                              │
                              ▼
┌─────────────────────────────────────────────────────────────┐
│ The operating state parameters and the edge-side fracture    │──  208
│ detection result are sent to the energy storage cloud for    │
│ the energy storage cloud to generate a fracture detection    │
│ result of the connection component according to the          │
│ cloud-side fracture detection result and the edge-side       │
│ fracture detection result, and the cloud-side fracture       │
│ detection result is predicted based on the operating state   │
│ parameters.                                                   │
└─────────────────────────────────────────────────────────────┘
```

FIG. 1

**Description**

TECHNICAL FIELD

The present disclosure relates to the technical field of energy storage battery management systems, particular to a fracture detection method and device for a connection component of an energy storage system, and an energy storage system.

BACKGROUND

With the continuous development of science and technology, energy storage systems have been widely used in many fields. An energy storage system includes multiple energy storage modules that achieve electrical connection and signal interaction through a Cell Contact System (CCS, i.e., an integrated busbar) and conductive parts such as nickel sheets, copper sheets, or nickel-plated copper sheets, thereby forming a complete system that can stably realize energy storage and release. As a critical connection component in the energy storage system, the reliability of CCS is crucial for the safe operation of the energy storage system.

SUMMARY

The first embodiment of the present invention is set out in the independent claim. Additional preferred embodiments are set out in the dependent claims.
In the fracture detection method and device for the connection component of the energy storage system and the energy storage system above, the energy storage edge first samples the operating state parameters of the at least one secondary battery connected by the connection component, and then based on the operating state parameters, analyzes the degree of dispersion of the operating state parameters of the at least one secondary battery to obtain the parameter discrete characteristic value, and then the energy storage edge, by using the parameter discrete characteristic value as an indicator, and combining with a preset discrete characteristic value threshold, performs a fracture detection for the connection component, and obtains the edge-side fracture detection result for fracture detection for the connection component, thereby achieving the purpose of initially detecting whether an abnormal fracture occurs to the connection component by analyzing the degree of dispersion of the operating state parameters at the energy storage edge. In addition, the energy storage edge sends the operating state parameters and the edge-side fracture detection result to the energy storage cloud, so that the energy storage cloud predicts a cloud-side fracture detection result based on the operating state parameters, thus achieving the purpose of determining whether an abnormal fracture occurs to the connection component by predicting the operating state parameters at the energy storage cloud. Finally, by comparing the edge-side fracture detection result and the cloud-side fracture detection result, the fracture detection result of the connection component can be obtained. Due to its proximity to the connection component, the energy storage edge enables real-time capture of operating state parameters and feature analysis, achieving rapid early warning of fractures in the connection component. Due to its strong computing capability, the energy storage cloud can accurately predict whether a fracture has occurred to the connection component based on the operating state parameters uploaded by the energy storage edge, and finally obtain the fracture detection result of the connection component through comparison and verification of results from both sides, thereby achieving the purpose of collaboratively completing the automatic fracture detection for the connection component by the energy storage edge and the energy storage cloud, instead of only relying on manual identification by the operator with the naked eyes, thus overcoming the technical problems, such as detection delay, detection errors, or excessively long detection time, which are caused by the limited recognition ability of naked eyes and difficulty in matching the detection efficiency of the operator with the scale of the energy storage system. Therefore. the detection effect of the fracture detection for the connection component of the energy storage system is improved.

BRIEF DESCRIPTION OF DRAWINGS

To more clearly describe the technical solutions of the embodiments of the present application or in the prior art, drawings required to be used in the description of the embodiments or the related art are briefly introduced below. It is obvious that the drawings described below are only some embodiments of the present disclosure, and for those skilled in the art, other drawings may be obtained from these drawings without inventive efforts.

FIG. 1 is a schematic flowchart of a fracture detection method for a connection component of an energy storage system according to an embodiment.
FIG. 2 is a schematic flowchart of a fracture detection method for a connection component of an energy storage system according to another embodiment.

FIG. 3 is a schematic flowchart of determining a fracture detection result of a connection component according to an embodiment.

FIG. 4 is a block diagram showing a structure of a fracture detection device for a connection component of an energy storage system, which is applied to an energy storage edge according to an embodiment.

FIG. 5 is a block diagram showing a structure of a fracture detection device for a connection component of an energy storage system, which is applied to an energy storage cloud according to an embodiment.

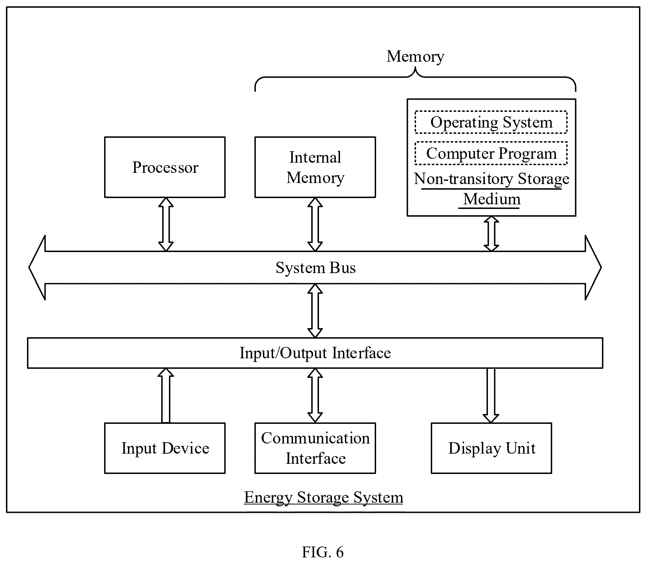

FIG. 6 is a view showing an internal structure of a computer according to an embodiment.

DETAILED DESCRIPTION OF EMBODIMENTS

To make the purpose, technical solutions, and advantages of the present disclosure clearer and better understood, the present disclosure is further described in detail in conjunction with the drawings and the embodiments. It should be understood that specific embodiments described herein are only for the purpose of explaining the present disclosure, but not intended to limit the present disclosure.

First, it should be understood that a Cell Contact System (CCS, i.e., an integrated busbar), as an integrated connection component in a battery module, is configured to realize electrical connection and signal interaction between energy storage modules, and can also be referred to as a connection component of the energy storage system or a harness board integrated component. Nickel sheets, copper sheets, or nickel-plated copper sheets are critical parts for the CCS to realize electrical connection and signal interaction. Specifically, the nickel sheets, the copper sheets, or the nickel-plated copper sheets can all be referred to as conductive parts. If a conductive part breaks, such problems may be caused: a circuit interruption (in this case, secondary battery cells cannot participate in charging and discharging, thus reducing the capacity of the battery module), local overheating (caused by arcs or local high temperatures which may be generated at a fracture of the conductive part, thus accelerating the aging of insulating materials), and safety risks (such as thermal runaway in an extreme case). Therefore, the reliability of the connection component is crucial for a safe operation of the energy storage system, and the fracture detection for the connection component of the energy storage system refers to a fracture detection for the conductive parts, such as the nickel sheet, the copper sheet, or the nickel-plated copper sheet in the connection component.

Currently, in the process of performing a fracture detection for a connection component of the energy storage system, being limited by naked-eye recognition ability, and the detection efficiency of operators is unable to match the expanding scale of the energy storage system, thus causing problems such as detection delay, detection errors, and excessively long detection time. Therefore, the detection effect of the current fracture detection for the connection component of the energy storage system is poor.

In the related technology, the fracture detection for the conductive part is usually performed by an operator based on visual identification. For example, a crack, a deformation, or corrosion of a surface of the nickel sheet is detected by a high-power microscope or an optical sensor. For another example, when an excessive voltage difference or temperature difference is detected in a secondary battery during an end-of-line (EOL) testing or an integration testing of the battery pack, the battery pack will be opened to manually determine whether there is a fracture abnormality in the nickel sheet of the CCS. However, regardless of the detection method, it ultimately relies on the naked eyes of the operator. The visual identification ability of the operator is limited, and the efficiency of the manual detection is low, thus making it difficult for the detection to match the expanding scale of the energy storage system, and causing problems such as detection delay, detection errors, and excessively long detection time easily. Therefore, the current fracture detection method for the conductive part needs to be optimized, that is, there is a pressing need for a fracture detection method for the connection component of the energy storage system, which can improve the detection effect of the fracture detection for the connection component of the energy storage system.

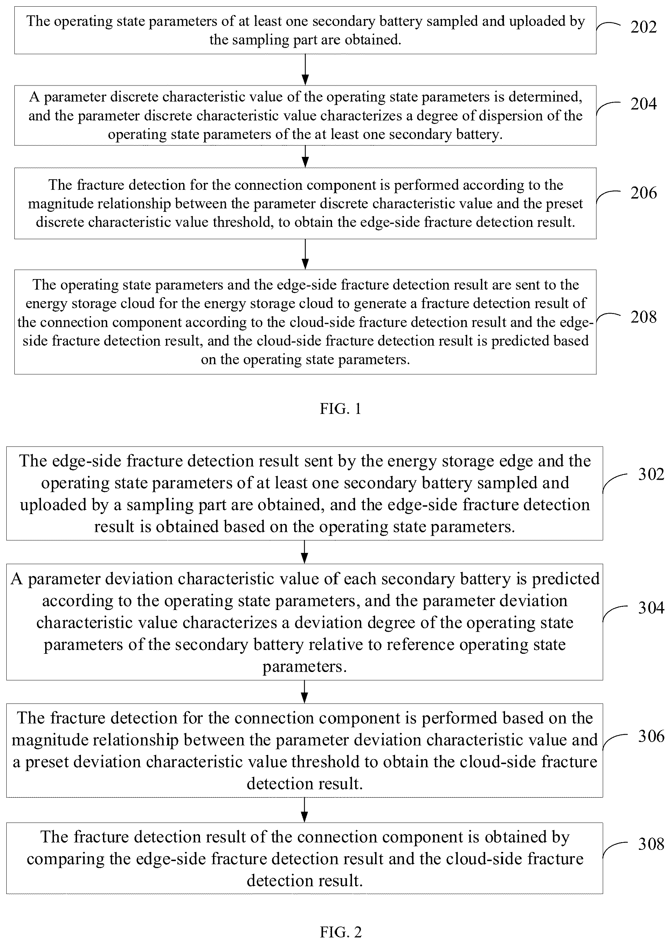

In an embodiment, as shown in FIG. 1, a fracture detection method for a connection component of an energy storage system is provided. Embodiments are implemented by taking the method applied to an energy storage edge as an example. The energy storage edge refers to a computing, control, and communication units deployed locally or in a nearby location of an energy storage device in the energy storage system, and is a layer closest to a physical device in the entire architecture of the energy storage system, and can also be referred to as an energy storage edge terminal, which may specifically include an embedded edge controller, an industrial-grade edge computing gateway, an intelligent sensor, or an actuator. The energy storage edge is deployed with a first acquiring module, a determining module, a first detecting module, and a sending module. The first acquiring module is configured to acquire operating state parameters of at least one secondary battery sampled and uploaded by a sampling part. The determining module is configured to determine a parameter discrete characteristic value of the operating state parameters. The parameter discrete characteristic value characterizes a degree of dispersion of the operating state parameters of each secondary battery. The first detecting module is configured to perform a fracture detection for the connection component according to a magnitude relationship between the parameter discrete characteristic value and a preset discrete characteristic value threshold to obtain an edge-side fracture detection result. The sending module is configured to send operating state parameters and the edge-side fracture detection result to an energy storage cloud, so that the energy storage cloud generates a fracture detection result of the connection component according to a cloud-side fracture detection result and the edge-side fracture detection result. The cloud-side fracture detection result is predicted according to the operating state parameters. For example, in an implementable embodiment, the main function of the first acquiring module is configured to sample the operating state parameters of the energy storage device, and the first acquiring module may be deployed in an intelligent sensor or a data acquisition card of the energy storage edge. The main function of the determining module is to process and analyze the sampled operating state parameters, and the determining module may be deployed in an embedded edge controller or an industrial-grade edge computing gateway of the energy storage edge. The main function of the first detecting module is to perform a fracture detection for the connection component, and the first detecting module may also be deployed in an embedded edge controller or an industrial-grade edge computing gateway of the energy storage edge. The main function of the sending module is to exchange information with the energy storage cloud, and the sending module may be independently configured at the energy storage edge with a communication module such as a 4G/5G module, a Wi-Fi module, or an Ethernet module, or may be deployed in an industrial-grade edge computing gateway of the energy storage edge. The industrial-grade edge computing gateway has a communication function. Further, through information interchange between the first acquiring module, the determining module, the first detecting module, and the sending module, the purpose of preliminarily detecting the fracture abnormality of the connection component at the energy storage edge by analyzing the degree of dispersion of the operating state parameters can be achieved. In addition, the energy storage edge sends the operating state parameters and the edge-side fracture detection result to the energy storage cloud, so that the energy storage cloud predicts the cloud-side fracture detection result based on the operating state parameters, thereby achieving the purpose of obtaining the fracture abnormality of the connection component by predicting the operating state parameters at the energy storage cloud. Finally, by comparing the edge-side fracture detection result and the cloud-side fracture detection result, the fracture detection result of the connection component can be obtained, thereby achieving the purpose of collaboratively completing an automatic fracture detection for the connection component by the energy storage edge and the energy storage cloud. Therefore, the fracture detection for the conductive part can be completed accurately and efficiently, and the detection effect of the fracture detection for the connection component of the energy storage system can be improved. In the embodiment, the method includes the following steps 202 to 208.

In step 202, the operating state parameters of at least one secondary battery sampled and uploaded by the sampling part are obtained.

The connection component is the CCS of the energy storage module, and as a core integrated module of the energy storage module, is directly embedded inside the energy storage module. The energy storage module is a basic energy unit of the energy storage system, and forms a complete energy storage system through multi-level integration. Specifically, the energy storage module includes a plurality of secondary batteries connected in a certain manner. The secondary battery refers to a battery that can be recharged repeatedly, for example, a lithium-ion battery. The connection component includes a conductive part and a sampling part. The sampling part is configured to sample the operating state parameters of the battery in the energy storage module, thereby providing a decision-making basis for the Battery Management System (BMS), and specifically, the sampling part may be a Flexible Printed Circuit (FPC), a Flexible Flat Cable (FFC), or a Flexible Die Cutting (FDC), etc. The conductive part is configured to realize high-voltage series and/or parallel connections of battery cells and transmissions of signals of the battery cells, ensuring a stable current flow, and specifically the conductive part may be an aluminum-copper busbar, a nickel sheet, a copper sheet, or a nickel-plated copper sheet, etc. The sampling part can be connected to the conductive part through welding or a hot-pressing process, so as to transmit signals of the battery cells to the BMS. The BMS is configured to manage and maintain the secondary batteries of each unit, monitor the operating states of the secondary batteries, and prevent overcharging and over-discharging of the secondary batteries. Specifically, the BMS includes a Battery Management Unit (BMU), a Battery Control Unit (BCU), and a Storage Control Unit (SCU). The BMU is configured to sample the operating state parameters of the secondary battery and execute a balance control command, and send the operating state parameters of the secondary battery and the balance control command to the BCU through the Controller Area Network (CAN) communication protocol. The BCU is configured to process battery data and estimate a battery state, perform a safety protection, and send the processed battery data and the estimated battery state to the SCU through the communication protocol of the Modbus Transmission Control Protocol (Modbus TCP). The SCU is configured to perform a numerical calculation, a performance analysis, an alarm processing, and a record storage for real-time battery data, and configured to clean edge data and send the cleaned data, such as voltage, current, and temperature, to the energy storage cloud through the Message Queuing Telemetry Transport protocol (MQTT). In addition, the connection component may further include a structural support part and an insulation protection part. The structural support part is configured to fix the battery cells with the sampling part and the conductive part, thereby ensuring the structural strength and space utilization rate of the connection component, and specifically, the structural support part may be an injection-molded bracket or a blister isolation plate. The insulation protection part is configured to prevent short circuit and overheating of the battery cells, thereby improving system safety, and specifically, the insulation protection part may be a hot-pressed insulation film or a fuse, etc. For example, in an embodiment, the energy storage module is a secondary battery module, and specifically, a lithium-ion battery module. The connection part is a nickel sheet. The sampling part includes a sampling line. The nickel sheet is directly connected to the tabs of the lithium-ion battery cells in the lithium-ion battery module by welding to ensure current conduction. The connection part integrates the busbar, the sampling line, a connector, etc. The busbar is connected to the nickel sheet to realize the series and/or parallel connections of the multiple battery cells. The sampling line contacts the battery cells or the nickel sheet through a specific structure, so as to sample the operating state parameters of the lithium-ion battery.

The quantity of the secondary batteries electrically connected by the conductive part is not specifically limited in the embodiments, and specifically, may be 12, 24, 48, 13, or 26, etc. For example, in an embodiment, the conductive part is electrically connected to 52 series-connected secondary batteries in one battery module. The operating state parameter represents a physical quantity or electrical quantity that characterizes the current operating state of the secondary batteries, and specifically, may include a voltage, a temperature, a current, and a State of Charge (SOC), etc. The sampling part may be an independent sampling module deployed in the connection component, for example, a voltage acquisition chip, a temperature sensor, a current sensor, and the sampling part may be an integrated sampling module, for example, a sampling harness and a sampling board integrated in the connection component, which can simultaneously sample the voltage and temperature of the secondary battery.

Exemplarily, the step 202 includes obtaining the operating state parameters of the at least one secondary battery uploaded by the sampling part. The operating state parameters are sampled by the sampling part.

In step 204, a parameter discrete characteristic value of the operating state parameters is determined, and the parameter discrete characteristic value characterizes a degree of dispersion of the operating state parameters of the at least one secondary battery.

The parameter discrete characteristic value characterizes the degree of dispersion of the operating state parameters of each secondary battery, and specifically, may be a temperature discrete characteristic value, a voltage discrete characteristic value, or a current discrete characteristic value, etc. Specifically, the parameter discrete characteristic value corresponding to the operating state parameters may be calculated through the respective parameter characteristic values of the operating state parameters. A parameter characteristic value represents a quantitative metric in a specific dimension of an operating state parameter of a single secondary battery. For example, when the parameter discrete characteristic value is a temperature discrete characteristic value, the parameter characteristic value may be, for example, an actual operating temperature value, a temperature change rate of a single secondary battery, or a temperature difference between an actual temperature and an ambient temperature. For example, in an embodiment, there are $n$ secondary batteries in total, the sampled operating state parameters are actual operating temperature values of the $n$ secondary batteries, denoted as $T_1$, $T_2$, $\cdots$, $T_{n-1}$, $T_n$, respectively. The average temperature value of the $n$ secondary batteries is $T'$, and an expression of $T'$ is as follows:

$$T' = \frac{T_1 + T_2 + \cdots + T_{n-1} + T_n}{n}$$

Further, squares of the differences between the actual operating temperature value of each of the secondary batteries and the average temperature value are calculated and denoted as $(T_1 - T')^2$, $(T_2 - T')^2$, $\cdots$, $(T_{n-1} - T')^2$, $(T_n - T')^2$ in sequence. In addition, the average value S' of squared temperature differences is calculated, an expression of S' is as follows:

$$S' = \frac{1}{n}\sum_{i=1}^{n}(T_i - T')^2 = \frac{(T_1 - T')^2 + (T_2 - T')^2 + \cdots + (T_{n-1} - T')^2 + (T_n - T')^2}{n}$$

$S'$ represents the average value of squared temperature differences, $T_1$, $T_2$, $\cdots$, $T_{n-1}$, $T_n$ represent the actual operating temperature values, and $T'$ represents the average temperature value. The temperature discrete characteristic value $S$ is calculated based on the average value of the squared temperature differences. The expression of $S$ is as the following expression.

$$S = \sqrt{S'} = \sqrt{\frac{1}{n}\sum_{i=1}^{n}(T_i - T')^2}$$

$S$ may be used to characterize the degree of dispersion of the actual operating temperature values relative to the average temperature of the $n$ secondary batteries. The larger $S$ is, the greater the degree of temperature dispersion is. The smaller *S* is, the lower the degree of temperature dispersion is.

Exemplarily, the step 204 includes fusing the operating state parameters to obtain the parameter discrete characteristic value of the operating state parameters.

In step 206, the fracture detection for the connection component is performed according to the magnitude relationship between the parameter discrete characteristic value and the preset discrete characteristic value threshold, to obtain the edge-side fracture detection result.

By comparing the parameter discrete feature values and the preset discrete characteristic value threshold, whether a fracture has occurred to the connection component can be determined. Specifically, whether a fracture has occurred to the connection sheet, such as the nickel sheet, the copper sheet, or the nickel-plated copper sheet in the connection component, can be determined. The edge-side fracture detection result represents the fracture detection result of the connection component obtained by the energy storage edge. The edge-side fracture detection result includes the result that the connection component has a fracture abnormality or that the connection component has no fracture abnormality. The preset discrete characteristic value threshold may be set according to requirements.

Exemplarily, the step 206 includes obtaining the edge-side fracture detection result that the connection component has a fracture abnormality, in response to a determination that the parameter discrete characteristic value is greater than the preset discrete characteristic value threshold. Alternatively, the step 206 further includes obtaining the edge-side fracture detection result that the connection component has no fracture abnormality, in response to a determination that the parameter discrete characteristic value is less than or equal to the preset discrete characteristic value threshold.

In step 208, the operating state parameters and the edge-side fracture detection result are sent to the energy storage cloud for the energy storage cloud to generate a fracture detection result of the connection component according to the cloud-side fracture detection result and the edge-side fracture detection result, and the cloud-side fracture detection result is predicted based on the operating state parameters.

The determination of whether a fracture has occurred to the connection component made by the energy storage edge has a certain limitation, which is specifically reflected in the following two aspects. Firstly, the energy storage edge can only sample partial local parameters and has difficulty in obtaining global data, thus the energy storage edge is unable to perform the fracture detection for the connection component under a global operating situation. Secondly, a need for a real-time detection cannot be satisfied, and the algorithms deployed at the energy storage edge mostly use a lightweight model which has a recognition accuracy not high enough for complex scenarios. However, the actual application scenarios of the connection component are complex and changeable, therefore, after the edge-side fracture detection result is obtained, the energy storage cloud is required to collaboratively generate the fracture detection result of the connection component.

The energy storage cloud is a remote server cluster or platform constructed based on cloud computing technology for energy storage system management and data analysis, and specifically, the energy storage cloud may be a centralized management platform or an energy storage cloud platform of a large-scale energy storage power station. The cloud-side fracture detection result represents the fracture detection result of the connection component obtained by the energy storage cloud. The cloud-side fracture detection result includes a cloud-side fracture detection result that the connection component has a fracture abnormality, or a cloud-side fracture detection result that the connection component has no fracture abnormality. For example, in an implementable embodiment, when the edge-side fracture detection result that the connection component has a fracture abnormality and the cloud-side fracture detection result that the connection component has a fracture abnormality are obtained, a fracture detection result that the connection component has a fracture abnormality is determined and obtained, that is, the connection component is in an abnormal operating state, and specifically, there may be a nickel sheet fracture or a nickel sheet abnormality.

Exemplarily, the step 208 includes sending the operating state parameters and the edge-side fracture detection result to the energy storage cloud, so that the energy storage cloud generates the fracture detection result of the connection component according to the cloud-side fracture detection result and the edge-side fracture detection result. The cloud-side fracture detection result is predicted based on the operating state parameters.

In an implementable embodiment, the energy storage cloud is a cloud platform constructed based on an Internet of Things (IoT) framework, providing a full data life-cycle management, which may specifically include following data management. 1) Data collection: receiving real-time data uploaded by the SCU. 2) Data cleaning: removing abnormal values from the data to ensure data quality. 3) Data storage, establishing a time-series database to support a retrieval of historical data. 4) Data visualization, displaying the operating state of the secondary battery through a visual monitoring platform to assist decision-making in operation and maintenance. The cloud platform provides a reliable data support for subsequent big data analysis and model training. Specifically, the cloud platform is deployed with a cloud processor, and the main functions of the cloud processor are as follows. 1) Digital twin modeling: constructing a battery voltage model or a battery temperature prediction model based on historical data to simulate an actual operating state of the secondary battery. 2) Residual analysis: comparing predicted data with actual data to identify an abnormal operating fluctuation. 3) Fault diagnosis: locating faults, such as a fracture of the nickel sheet in the CCS, etc., by using an algorithm, and providing specific maintenance suggestions.

In the above fracture detection method for the connection component of the energy storage system, the energy storage edge first samples the operating state parameters of the at least one secondary battery connected by the connection component, and then based on the operating state parameters, analyzes the degree of dispersion of the operating state parameters of the at least one secondary battery to obtain the parameter discrete characteristic value, and then the energy storage edge, by using the parameter discrete characteristic value as an indicator, and combining with a preset discrete characteristic value threshold, performs a fracture detection for the connection component, and obtains the edge-side fracture detection result for fracture detection for the connection component, thereby achieving the purpose of initially detecting whether an abnormal fracture occurs to the connection component by analyzing the degree of dispersion of the operating state parameters at the energy storage edge. In addition, the energy storage edge sends the operating state parameters and the edge-side fracture detection result to the energy storage cloud, so that the energy storage cloud predicts a cloud-side fracture detection result based on the operating state parameters, thus achieving the purpose of determining whether an abnormal fracture occurs to the connection component by predicting the operating state parameters at the energy storage cloud. Finally, by comparing the edge-side fracture detection result and the cloud-side fracture detection result, the fracture detection result of the connection component can be obtained. Due to its proximity to the connection component, the energy storage edge enables real-time capture of operating state parameters and feature analysis, achieving rapid early warning of fractures in the connection component. Due to its strong computing capability, the energy storage cloud can accurately predict whether a fracture has occurred to the connection component based on the operating state parameters uploaded by the energy storage edge, and finally obtain the fracture detection result of the connection component through comparison and verification of results from both sides, thereby achieving the purpose of collaboratively completing the automatic fracture detection for the connection component by the energy storage edge and the energy storage cloud, instead of only relying on manual identification by the operator with the naked eyes, thus overcoming the technical problems, such as detection delay, detection errors, or excessively long detection time, which are caused by the limited recognition ability of naked eyes and difficulty in matching the detection efficiency of the operator with the scale of the energy storage system. Therefore. the detection effect of the fracture detection for the connection component of the energy storage system is improved.

In an embodiment, the parameter discrete characteristic value includes a first parameter discrete characteristic value. Determining the parameter discrete characteristic value of the operating state parameters including: determining a first parameter characteristic value corresponding to the operating state parameters, and determining a second parameter characteristic value corresponding to the operating state parameters. The first parameter characteristic value and the second parameter characteristic value are parameter characteristic values of different dimensions. The first parameter discrete characteristic value is obtained by fusing the first parameter characteristic value and the second parameter characteristic value.

Since a single-parameter discrete characteristic value is susceptible to noise interference, a multi-parameter discrete characteristic value can be used as a detection basis for a fracture detection for the connection component. The first parameter discrete characteristic value characterizes a deviation degree of the operating state parameters from a normal range in the data distribution, and specifically, may be a numerical value calculated based on a standard Z-score algorithm. Specifically, the first parameter characteristic value may be a sample mean, and the second parameter characteristic value may be a sample standard deviation. The first parameter characteristic value and the second parameter characteristic value are parameter characteristic values of different dimensions, that is, are parameter characteristic values reflecting the degree of dispersion of the operating state parameters from different dimensions.

Exemplarily, the first parameter characteristic value corresponding to the operating state parameters is calculated through a first preset expression. The first preset expression is as follows:

$$\mu = \frac{1}{n}\sum_{i=1}^{n} x_i \qquad (1)$$

where, $\mu$ represents the first parameter characteristic value, which may specifically be a sample mean, $i$ represents a number of the $i$-th secondary battery, $n$ represents the quantity of the secondary batteries, and $x_i$ represents the operating state parameter of the $i$-th secondary battery.

The second parameter characteristic value corresponding to the operating state parameters is calculated through a second preset expression. The second preset expression is as follows:

$$\sigma = \sqrt{\frac{1}{n}\sum_{i=1}^{n}(x_i - \mu)} \qquad (2)$$

where, $\sigma$ represents the second parameter characteristic value, which may specifically be a sample standard deviation, $\mu$ represents the first parameter characteristic value, which may specifically be the sample mean, $i$ represents a number of the $i$-th secondary battery, $n$ represents the quantity of the secondary batteries, and $x_i$ represents the operating state parameter of the $i$-th secondary battery.

The first parameter discrete characteristic value is obtained by fusing the first parameter characteristic value and the second parameter characteristic value through a third preset expression. The third preset expression is as follows:

$$Z_i = \frac{x_i - \mu}{\sigma} \qquad (3)$$

where, $Z_i$ represents the first parameter discrete characteristic value, $\sigma$ represents the second parameter characteristic value, which may specifically be the sample standard deviation, and $x_i$ represents the operating state parameter of the i-th secondary battery.

In this way, by determining the first parameter characteristic value and second parameter characteristic value of the operating state parameters in different dimensions, and fusing the first parameter characteristic value and the second parameter characteristic value to obtain the first parameter discrete characteristic value, the degree of dispersion of the operating state parameters can be accurately and comprehensively evaluated, thereby providing a more reliable basis for the energy storage edge to perform the fracture detection for the connection component, and laying a foundation for improving the detection effect of the fracture detection for the connection component of the energy storage system.

In an embodiment, the parameter discrete characteristic value includes a second parameter discrete characteristic value, and determining the parameter discrete characteristic value of the respective operating state parameters includes: selecting an operating state characteristic parameter from the operating state parameters based on the magnitudes of the operating state parameters, and obtaining a second parameter discrete characteristic value by fusing each of the operating state parameters and the operating state characteristic parameter.

The second parameter discrete characteristic value characterizes fluctuation and discreteness of each of the operating state parameters relative to the operating state characteristic parameter, and may specifically be a numerical value calculated based on a robust Z-score algorithm. The operating state characteristic parameter represents an operating state parameter with a specific characteristic, and may specifically be a median.

Exemplarily, the operating state parameters are arranged in a descending order according to their magnitudes to form an operating state parameter sequence, the operating state parameter located at the middle position in the operating state parameter sequence is selected as the operating state characteristic parameter. The operating state parameters and the operating state characteristic parameter are fused through a fourth preset expression to obtain the second parameter discrete characteristic value. The fourth expression is as follows:

$$Z_i^{robust} = \frac{x_i - \dot{X}}{c \cdot MAD} \qquad (4)$$

where $Z_i^{robust}$ represents the second parameter discrete characteristic value, $\dot{X}$ represents the operating state characteristic parameter, which may specifically be a median, $x_i$ represents the operating state parameter of the $i$-th secondary battery, c represents a consistency constant, which may specifically be set to 1.4826, and $MAD = median\,(x_i - \dot{X})$ specifically refers to an absolute deviation value of the median.

In this way, firstly, by comparing the magnitudes of the operating state parameters one by one, the operating state characteristic parameter is selected from the operating state parameters, and finally, the second parameter discrete characteristic value is obtained by fusing the operating state characteristic parameter and each of the operating state parameters in sequence, thereby accurately capturing subtle changes in the connection component during operation, thus further providing a more reliable basis for the energy storage edge to perform a fracture detection for the connection component, and further laying a foundation for improving the detection effect of the fracture detection for the connection component of the energy storage system.

In an embodiment, the parameter discrete characteristic value includes the first parameter discrete characteristic value and the second parameter discrete characteristic value, and the preset discrete characteristic value threshold includes a first preset discrete characteristic value threshold and a second preset discrete characteristic value threshold. Performing the fracture detection for the connection component according to the magnitude relationship between the parameter discrete characteristic value and the preset discrete characteristic value threshold to obtain the edge-side fracture detection result includes: determining the magnitude relationship between the first parameter discrete characteristic value and the first preset discrete characteristic value threshold, and determining the magnitude relationship between the second parameter discrete characteristic values and the second preset discrete characteristic value threshold; generating the edge-side fracture detection result according to the first parameter discrete characteristic value and the second parameter discrete characteristic value in response to the determination that the first parameter discrete characteristic value is greater than the first preset discrete characteristic value threshold and the second parameter discrete characteristic value is greater than the second preset discrete characteristic value threshold; using first preset component state information as the edge-side fracture detection result in response to the determination that the first parameter discrete characteristic value is less than or equal to the first preset discrete characteristic value threshold, and/or that the second parameter discrete characteristic value is less than or equal to the second preset discrete characteristic value threshold. The first preset component state information represents that the energy storage edge determines that the connection component is in a normal operating state.

In the case of performing the fracture detection for the connection component through the first parameter discrete characteristic value and the second parameter discrete characteristic value which are determined by multiple parameters, the discrete characteristic value thresholds can be set for the first parameter discrete characteristic value and the second parameter discrete characteristic value, respectively. The judgment results of the magnitude relationship between the two groups of parameter discrete characteristic values and discrete characteristic value thresholds are jointly used as the determination basis for determining whether the connection component has a fracture. The first preset discrete characteristic value threshold and the second preset discrete characteristic value threshold may be the same or different.

Exemplarily, the magnitude of the first parameter discrete characteristic value is compared with the magnitude of the first preset discrete characteristic value threshold, and the magnitude of the second parameter discrete characteristic value is compared with the magnitude of the second preset discrete characteristic value threshold. The edge-side fracture detection result is generated according to the first parameter discrete characteristic value and the second parameter discrete characteristic value in response to the determination that the first parameter discrete characteristic value is greater than the first preset discrete characteristic value threshold and that the second parameter discrete characteristic value is greater than the second preset discrete characteristic value threshold, the target secondary battery which is abnormal is located, and the edge-side fracture detection result that the connection component connected to the target secondary battery is at an abnormal operating state is generated. The first preset component state information is used as the edge-side fracture detection result in response to the determination that the first parameter discrete characteristic value is less than or equal to the first preset discrete characteristic value threshold. Alternatively, the first preset component state information is used as the edge-side fracture detection result in response to the determination that the second parameter discrete characteristic value is less than or equal to the second preset discrete characteristic value threshold. Alternatively, the first preset component state information is used as the edge-side fracture detection result in response to the determination that the first parameter discrete characteristic value is less than or equal to the first preset discrete characteristic value threshold, and that the second parameter discrete characteristic value is less than or equal to the second preset discrete characteristic value threshold.

In an implementable embodiment, expressions for the fracture detection for the connection component based on the magnitude relationship between the parameter discrete characteristic value and the preset discrete characteristic value threshold is as follows:

$$|Z_i| > T_1$$

$$\left|Z_i^{robust}\right| > T_2$$

Where, $Z_i$ represents the first parameter discrete characteristic value, $Z_i^{robust}$ represents the second parameter discrete characteristic value, $T_1$ represents the first preset discrete characteristic value threshold, and the specific range thereof may be [0.02V, 0.05V], that is, the first preset discrete characteristic value threshold may be in a range from 0.02V to 0.05V. $T_2$ represents the second preset discrete characteristic value threshold, and the specific range thereof may be [3°C, 5°C], that is, the second preset discrete characteristic value threshold may be in a range from 3°C to 5°C. When these expressions are satisfied, the edge-side fracture detection result that the connection component is in the abnormal operating state is generated by the energy storage edge.

In the embodiment, during the fracture detection for the connection component, the magnitude relationships between the first and second parameter discrete characteristic values and their respective corresponding preset discrete characteristic value thresholds are jointly used as the determination basis for determining whether the connection component has a fracture, so that the fracture characteristic of the connection component can be captured more accurately and comprehensively, thereby reducing the possibility of misjudgment or false judgment caused by a single-parameter determination, and further laying a foundation for improving the detection effect of the fracture detection for the connection component of the energy storage system.

In an embodiment, the first parameter discrete characteristic value is a voltage discrete characteristic value, and the second parameter discrete characteristic value is a temperature discrete characteristic value. Generating the edge-side fracture detection result that according to the first parameter discrete characteristic value and the second parameter discrete characteristic value includes: selecting a first target secondary battery with abnormal voltage from the secondary batteries according to an operating state parameter corresponding to the voltage discrete characteristic value, and selecting a second target secondary battery with abnormal temperature from the secondary batteries according to an operating state parameter corresponding to the temperature discrete characteristic value; locating at least one first abnormal point with abnormal voltage on the connection component according to a connection relationship between the first target secondary battery and the connection component; locating at least one second abnormal point with abnormal temperature on the connection component according to a heat conduction path of the second target secondary battery; obtaining a target abnormal point on the connection component by fusing each first abnormal point and each second abnormal point; and generating the edge-side fracture detection result according to first position information of the target abnormal point.

The voltage discrete characteristic value characterizes a degree of voltage dispersion of the secondary battery relative to a normal distribution during the operation of the secondary battery. When the connection component is abnormal, the voltage fluctuation will intensify, which will lead to an increase in the voltage discrete characteristic value. The temperature discrete characteristic value characterizes a degree of temperature dispersion of the secondary battery over time. When the connection component is abnormal, local resistance will increase, thus causing an abnormal temperature distribution. The operating state parameters corresponding to the voltage discrete characteristic value may specifically be sampled real-time voltage values, and the operating state parameters corresponding to the temperature discrete characteristic value may specifically be sampled real-time temperature values. The heat conduction path refers to a physical path through which heat is transferred from a heat source to the surrounding environment via a transfer component. The first target secondary battery represents a secondary battery with abnormal voltage. The second target secondary battery represents a secondary battery with abnormal temperature. The target abnormal position represents a high-confidence abnormal position on the connection component. During the fracture detection for the connection component, the energy storage edge can not only detect whether the connection component has a fracture, but also determine an actual fracture position on the connection component when a fracture of the connection component is detected.

Exemplarily, by comparing the operating state parameter corresponding to the voltage discrete characteristic value, the first target secondary battery with abnormal voltage is selected from the secondary batteries, and by comparing the operating state parameter corresponding to the temperature discrete characteristic value, the second target secondary battery with abnormal temperature is selected from the secondary batteries. At least one first abnormal point with abnormal voltage on the connection component is located according to the connection relationship between the first target secondary battery and the connection component. A heat conduction path model of the second target secondary battery is constructed according to the heat conduction path of the second target secondary battery, and the second abnormal point of the second target secondary battery is predicted through the heat conduction path model. The overlapping abnormal points among the first and second abnormal points are used as the target abnormal point on the connection component. The first position information of the target abnormal point is encapsulated as the edge-side fracture detection result.

In an implementation, the conductive part is the nickel sheet. There are 13 secondary batteries in total, numbered 1, 2, 3, ..., 12, and 13 in sequence. By pairwise comparing the real-time sampled voltage values between the 13 batteries, the secondary battery with the maximum voltage fluctuation, i.e., the first target secondary battery with voltage abnormality is obtained. For example, the first target secondary batteries are the 1st, 5th, 7th, and 8th secondary batteries. Furthermore, by pairwise comparing the real-time sampled temperature values of the 13 batteries, the secondary batteries with the maximum temperature fluctuation, i.e., the second target secondary batteries with temperature abnormality are obtained. For example, the second target secondary batteries are the 2nd, 5th, 9th, and 12th secondary batteries. Thus, the first abnormal points are the connection positions between each of the 1st, 5th, 7th, and 8th secondary batteries and the nickel sheet, and the second abnormal points are the connection positions between each of the 2nd, 5th, 9th, and 12th secondary batteries and the nickel sheet. Further, the overlapping abnormal points (the connection position between the nickel sheet and the 5th secondary battery) among the first and second abnormal points is used as the target abnormal point. Thus, the edge-side fracture detection result is that a fracture occurs at the connection position between the nickel sheet and the 5th secondary battery.

In the embodiment, when it is determined that a fracture occurs to the connection component, the first target secondary battery with voltage abnormality and the second target secondary battery with temperature abnormality are located through the discrete characteristic values of different parameters, and then the target abnormal point on the connection component is selected from the first abnormal points of the first target secondary batteries and the second abnormal points of the second target secondary batteries. Finally, based on the first position information of the target abnormal point, the edge-side fracture detection result is generated, thereby achieving the purpose of accurately locating the fracture position on the connection component, and laying a foundation for further improving the detection effect of the fracture detection for the connection component of the energy storage system.

In an embodiment, obtaining a target abnormal point on the connection component by fusing each first abnormal point and each second abnormal point includes: determining at least one candidate abnormal point in an intersection of the at least one first abnormal point and the at least one second abnormal point; prioritizing the at least one candidate abnormal point according to the second position information of the candidate abnormal points to obtain a prioritization result; and selecting the target abnormal point from the candidate abnormal points according to the prioritization result.

The candidate abnormal point is defined as a position where the first abnormal point and the second abnormal point are spatially overlapping or adjacent. When there are multiple candidate abnormal points, the target abnormal point can be selected from the candidate abnormal points based on the positional priority relationship among the candidate abnormal points. For example, in an implementation, since head and tail positions are stress concentration areas with poor heat dissipation conditions, higher priority is assigned to the head and tail positions. The prioritization result represents the result of ranking the candidate abnormal points based on the mapping relationship between position and risk level.

Exemplarily, the at least one abnormal point in the intersection of the first abnormal points and the second abnormal points is used as the candidate abnormal point. Risk levels of the candidate abnormal points are queried according to the second position information of the candidate abnormal points. The risk levels of the candidate abnormal points are sorted from the highest to the lowest to obtain the prioritization result. The candidate abnormal point with the highest priority in the prioritization result is used as the target abnormal point. As such, in the process of determining the target abnormal point, the at least one candidate abnormal point is determined first, and then the candidate abnormal points are prioritized to obtain the prioritization result, and finally, based on the prioritization result, the target abnormal point is selected from the candidate abnormal points, thereby avoiding detection result interference caused by numerous redundant abnormal points while focusing on the highest-risk potential fracture positions, and further laying a foundation for improving the detection effect of the fracture detection for the connection component of the energy storage system.

In an embodiment, prioritizing the at least one candidate abnormal point according to the second position information of the at least one candidate abnormal point to obtain the prioritization result includes: determining the voltage abnormal characteristic value and the temperature abnormal characteristic value of each candidate abnormal point based on the second position information of each candidate abnormal point; determining a voltage abnormality weight value and a temperature abnormality weight value for each candidate abnormal point; fusing the voltage abnormal characteristic value and the temperature abnormal characteristic value based on the voltage abnormality weight value and the temperature abnormality weight value to obtain a comprehensive abnormal characteristic value of each candidate abnormal point; prioritizing the candidate abnormal points according to the comprehensive abnormal characteristic values to obtain the prioritization result.

The voltage abnormal characteristic value characterizes a deviation of the voltage of the candidate abnormal point from a normal state thereof. The temperature abnormal characteristic value characterizes a deviation of the temperature of the candidate abnormal point from a normal state thereof. Since different types of abnormalities vary in their influence on the fracture of the connection component, weights can be configured for different abnormal characteristic values accordingly, and the comprehensive abnormal characteristic value can be obtained through the fusion and quantification of characteristic values. The comprehensive abnormal characteristic value is used for prioritizing.

Exemplarily, the voltage abnormal characteristic value and the temperature abnormal characteristic value of each candidate abnormal point are obtained through the second position information of each the candidate abnormal point. The voltage abnormal weight value and the temperature abnormal weight value are assigned to each candidate abnormal point. The voltage abnormal weight value, the temperature abnormal weight value, the voltage abnormal characteristic value, and the temperature abnormal characteristic value are input into a preset expression to calculate the comprehensive abnormal characteristic value of the candidate abnormal point. The preset expression is as follows:

$$P_0 = \alpha_1 \cdot P_1 + \alpha_2 \cdot P_2$$

where, $P_0$ represents the comprehensive abnormal characteristic value, $\alpha_1$ represents the voltage abnormal weight value, $P_1$ represents the voltage abnormal characteristic value, $\alpha_2$ represents the temperature abnormal weight value, and $P_2$ represents the temperature abnormal characteristic value.

Prioritized the candidate abnormal points in the order of the comprehensive abnormal characteristic values from the largest to the smallest to obtain the prioritization result. As such, by assigning weight values for the abnormal characteristic values respectively and prioritizing the comprehensive abnormal characteristic values obtained by the fusion, thereby ensuring that the prioritization more accurately reflects actual malfunction patterns, thus laying the foundation for improving the accuracy of selecting the target abnormal points.

In an embodiment, as shown in FIG. 2, a fracture detection method for a connection component of an energy storage system is provided. Embodiments are implemented by taking the method applied to an energy storage cloud as an example. The energy storage cloud refers to a cloud platform that performs remote monitoring, data management, analysis and decision-making, and intelligent operation and maintenance for the energy storage system based on cloud computing technology. The energy storage cloud includes, but is not limited to, a personal computer and a laptop computer, etc. The energy storage cloud is deployed with a fracture detection system for the connection component of the energy storage system. The fracture detection system for the connection component includes a second acquiring module, a predicting module, a second detecting module, and a comparing module. The second acquiring module is configured to obtain the edge-side fracture detection result sent by the energy storage edge and the operating state parameters of the at least one secondary battery sampled and uploaded by the sampling part. The edge-side fracture detection result is obtained based on the operating state parameters. The predicting module is configured to predict parameter deviation characteristic values of the secondary batteries according to the operating state parameters. The parameter deviation characteristic value characterizes a deviation degree of the operating state parameters of a secondary battery relative to a reference operating state parameter. The second detecting module is configured to perform the fracture detection for the connection component according to the magnitude relationship between the parameter deviation characteristic value and the preset deviation characteristic value threshold to obtain the cloud-side fracture detection result. The comparing module is configured to obtain the fracture detection result of the connection component by comparing the edge-side fracture detection result and the cloud-side fracture detection result. Further, through information interchange between the second acquiring module, the second detecting module, and the comparing module, the purpose of detecting the fracture abnormality of the connection component through the energy storage cloudy predicting based on the operating state parameters. Finally, the energy storage cloud can obtain the fracture detection result of the connection component by comparing the edge-side fracture detection result and the cloud-side fracture detection result, thereby achieving the purpose of collaboratively completing an automatic fracture detection for the connection component by the energy storage edge and the energy storage cloud. Therefore, the fracture detection for the conductive part can be completed accurately and efficiently, and thus the detection effect of fracture detection for the connection component of the energy storage system can be improved. In an embodiment, the fracture detection method for the connection component of the energy storage system includes the following steps 302 to 308.

In step 302, the edge-side fracture detection result sent by the energy storage edge and the operating state parameters of at least one secondary battery sampled and uploaded by a sampling part are obtained, and the edge-side fracture detection result is obtained based on the operating state parameters.

For the step of the energy storage edge obtaining the edge-side fracture detection result based on the operating state parameters, reference may be made to the above embodiments, which will not be repeatedly described in this embodiment.

Exemplarily, the step 302 includes obtaining the edge-side fracture detection result sent by the energy storage edge, and obtaining the operating state parameters of the at least one secondary battery, which are sampled and uploaded by the sampling part.

In step 304, a parameter deviation characteristic value of each secondary battery is predicted according to the operating state parameters, and the parameter deviation characteristic value characterizes a deviation degree of the operating state parameters of the secondary battery relative to reference operating state parameters.

The parameter deviation characteristic value characterizes the deviation degree of the operating state parameters of each secondary battery relative to the reference operating state parameters, and specifically, may be a voltage deviation characteristic value, a temperature deviation characteristic value, or a current deviation characteristic value. The reference operating state parameter refers to a standard operating parameter value of the secondary battery under an ideal operating condition, and is used as a basis for evaluating the operating state parameters of the secondary battery. Specifically, the parameter deviation characteristic value corresponding to the operating state parameters may be calculated based on the operating state parameters.

Exemplarily, the step 304 includes fusing the operating state parameters to obtain the parameter characteristic value of the operating state parameters, and using the parameter characteristic value as the parameter deviation characteristic value of the operating state parameters.

In step 306, the fracture detection for the connection component is performed based on the magnitude relationship between the parameter deviation characteristic value and a preset deviation characteristic value threshold to obtain the cloud-side fracture detection result.

Exemplarily, when it is determined that the parameter deviation characteristic value is greater than the preset deviation characteristic value threshold, a cloud-side fracture detection result that the connection component has a fracture abnormality is obtained. When it is determined that the parameter deviation characteristic value is less than or equal to the preset deviation characteristic value threshold, a cloud-side fracture detection result that the connection component has no fracture abnormality is obtained.

In step 308, the fracture detection result of the connection component is obtained by comparing the edge-side fracture detection result and the cloud-side fracture detection result.

During the fracture detection for the connection component collaboratively performed by the energy storage edge and the energy storage cloud, since the energy storage cloud can not only sample local partial parameters but also obtain global data, it can carry out the fracture detection for the connection component under the global operating conditions, thereby overcoming the limitation of the fracture detection for the connection component carried out by the energy storage edge, and obtaining the fracture detection result that objectively reflects the fracture of the connection component.

Exemplarily, the step 308 includes obtaining the fracture detection result that the connection component has a fracture abnormality in a case where both the cloud-side fracture detection result and the edge-side fracture detection result are that the connection component has a fracture abnormality; or obtaining the fracture detection result that the connection component has no fracture abnormality in a case where the cloud-side fracture detection result is that the connection component has no abnormality and the edge-side fracture detection result is that the connection component has an abnormality.

In another embodiment, the step 308 includes obtaining the fracture detection result that the connection component has a fracture abnormality in the case where both the cloud-side fracture detection result and the edge-side fracture detection result are that the connection component has a fracture abnormality; or obtaining the fracture detection result that the connection component has no fracture abnormality in the case where the edge-side fracture detection result is that the connection component has no abnormality, and the cloud-side fracture detection result is that the connection component has an abnormality.

In another embodiment, the step 308 includes obtaining the fracture detection result that the connection component has a fracture abnormality in the case where both the cloud-side fracture detection result and the edge-side fracture detection result are that the connection component has a fracture abnormality; or obtaining the fracture detection result that the connection component has no fracture abnormality in the case where both the edge-side fracture detection result and the cloud-side fracture detection result are that the connection component has no fracture abnormality.

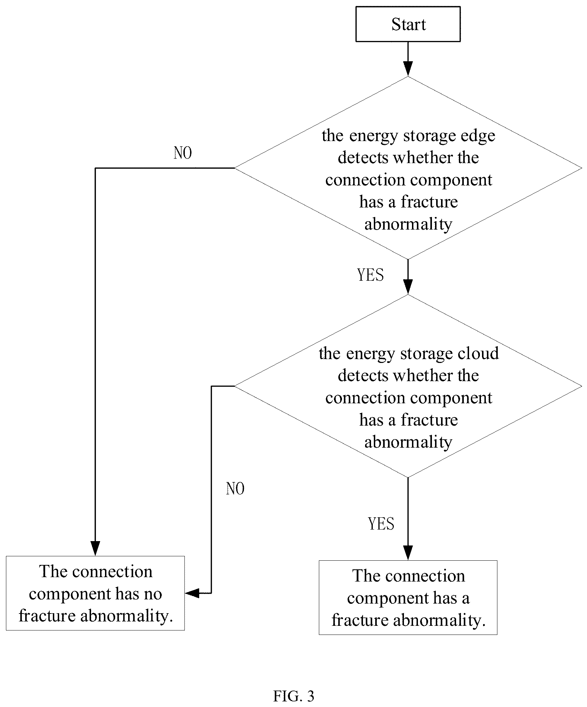

In an implementable embodiment, referring to FIG. 3, FIG. 3 is a schematic flowchart of determining a fracture detection result of a connection component. The fracture detection result that the connection component has a fracture abnormality is obtained only when both the cloud-side fracture detection result and the edge-side fracture detection result are that the connection component has a fracture abnormality. Otherwise, the fracture detection result that the connection component has no fracture abnormality is obtained.

In the above fracture detection method for the connection component of the energy storage system, firstly, the energy storage cloud collects the edge-side fracture detection result sent by the energy storage edge and the operating state parameters of the at least one secondary battery connected to the connection component. Then, the energy storage cloud predicts the parameter deviation characteristic values of the respective secondary batteries based on the operating state parameters, thereby achieving the purpose of obtaining the parameter deviation characteristic value that characterizes the deviation degree of the operating state parameters of each secondary battery relative to the reference operating state parameters. Further, the fracture detection for the connection component is performed by comparing the magnitude relationship between the parameter deviation characteristic value and the preset deviation characteristic value threshold to obtain the cloud-side fracture detection result. Finally, the fracture detection result of the connection component is obtained by comparing the edge-side fracture detection result and the cloud-side fracture detection result. Due to its proximity to the connection component, the energy storage edge enables real-time capture of operating state parameters and feature analysis, achieving rapid early warning of fractures in the connection component. Due to its strong computing capability, the energy storage cloud can accurately predict whether a fracture has occurred to the connection component based on the operating state parameters uploaded by the energy storage edge, and finally obtain the fracture detection result of the connection component through comparison and verification of results from both sides, thereby achieving the purpose of collaboratively completing the automatic fracture detection for the connection component by the energy storage edge and the energy storage cloud, instead of only relying on manual identification by the operator with the naked eyes, thus overcoming the technical problems, such as detection delay, detection errors, or excessively long detection time, which are caused by the limited recognition ability of naked eyes and difficulty in matching the detection efficiency of the operator with the scale of the energy storage system. Therefore. the detection effect of the fracture detection for the connection component of the energy storage system is improved.

In an embodiment, the parameter deviation characteristic value includes a voltage deviation characteristic value. Predicting the parameter deviation characteristic value of each secondary battery according to the operating state parameters includes: extracting a concentration polarization voltage value, a diffusion polarization voltage value, a concentration polarization resistance value, an ohmic resistance value, a diffusion polarization resistance value, a concentration polarization capacitance value, a diffusion polarization capacitance value, and an actual operating current value of each secondary battery from the operating state parameters; predicting a concentration polarization voltage characteristic value of each secondary battery according to the concentration polarization voltage value, the concentration polarization resistance value, the concentration polarization capacitance value, and the actual operating current value; and predicting a diffusion polarization voltage characteristic value of each secondary battery according to the diffusion polarization voltage value, the diffusion polarization resistance value, the diffusion polarization capacitance value, and the actual operating current value; fusing the concentration polarization voltage characteristic value, the diffusion polarization voltage characteristic value, the ohmic resistance value, and the actual operating current value to obtain the voltage deviation characteristic value of each secondary battery. The concentration polarization voltage characteristic value characterizes the variation of the concentration polarization voltage value with the actual operating current value. The diffusion polarization voltage characteristic value characterizes the variation of the diffusion polarization voltage value with the actual operating current value.

Since a single-parameter deviation characteristic value is also susceptible to noise interference, a multi-parameter deviation characteristic value can be used as a detection basis for a fracture detection for the connection component. The first parameter deviation characteristic value may specifically be a voltage value predicted by a voltage prediction model constructed based on a second-order equivalent circuit, and the least squares estimation method with a forgetting factor and an extended Kalman filtering algorithm are considered.

Exemplarily, the concentration polarization voltage value, the diffusion polarization voltage value, the concentration polarization resistance value, the ohmic resistance values, the diffusion polarization resistance value, the concentration polarization capacitance value, the diffusion polarization capacitance value, and the actual operating current value of each secondary battery are extracted from the operating state parameters. The concentration polarization voltage characteristic value of the secondary battery is calculated through a fifth preset expression based on the concentration polarization voltage value, the concentration polarization resistance value, the concentration polarization capacitance values, the ohmic resistance value, and the actual operating current value. The fifth preset expression is as follows:

$$\dot{U}_1 = -\frac{U_1}{R_1 C_1} + \frac{I}{C_1} \tag{5}$$

where, $\dot{U}_1$ represents the concentration polarization voltage characteristic value, $U_1$ represents the concentration polarization voltage value, $R_1$ represents the concentration polarization resistance value, $C_1$ represents the concentration polarization capacitance value, and $I$ represents the actual operating current value. The concentration polarization voltage characteristic value represents the variation of the concentration polarization voltage value with the actual operating current value.

The diffusion polarization voltage characteristic value of the secondary battery is calculated through a sixth preset expression based on the diffusion polarization voltage value, the diffusion polarization resistance value, the diffusion polarization capacitance value, and the actual operating current value. The sixth preset expression is as follows:

$$\dot{U}_2 = -\frac{U_2}{R_2 C_2} + \frac{I}{C_2} \tag{6}$$

where, $\dot{U}_2$ represents the diffusion polarization voltage characteristic value, $U_2$ represents the diffusion polarization voltage value, $R_2$ represents the diffusion polarization resistance value, $C_2$ represents the diffusion polarization capacitance value, and $I$ represents the actual operating current value. The diffusion polarization voltage characteristic value characterizes the variation of the diffusion polarization voltage value with the actual operating current value.

The voltage deviation characteristic value is calculated through a seventh preset expression based on the concentration polarization voltage characteristic value, the diffusion polarization voltage characteristic value, the ohmic resistance value, and the actual operating current value. The seventh preset expression is as follows:

$$U_t = OCV(SOC) - \dot{U}_1 - \dot{U}_2 - IR_0 \tag{7}$$

where, $\dot{U}_1$ represents the concentration polarization voltage characteristic value, $\dot{U}_2$ represents the diffusion polarization voltage characteristic value, $U_t$ represents the voltage deviation characteristic value, $I$ represents the actual operating current value, and $R_0$ represents the ohmic resistance value.

As such, by establishing the battery voltage prediction model based on the second-order equivalent circuit and considering the least squares estimation method with the forgetting factor and the extended Kalman filter algorithm, the deviation degree of any operating state parameter relative to the reference operating state parameter can be accurately and comprehensively evaluated, thus providing a more reliable basis for the energy storage cloud to perform the fracture detection for the connection component, thereby laying the foundation for improving the detection effect of the fracture detection for the connection component of the energy storage system.

In an embodiment, the parameter deviation characteristic value includes a temperature deviation characteristic value. Predicting the parameter deviation characteristic value of each secondary battery according to the operating state parameters includes: extracting a heat capacity value, a thermal resistance value, an actual operating temperature value, and an ambient temperature value of each secondary battery from the operating state parameters; predicting the temperature deviation characteristic value of each secondary battery based on the heat capacity value, the thermal resistance value, the actual operating temperature value, and the ambient temperature value.

A thermodynamic model is established based on the equivalent circuit model to perform a battery cell temperature prediction, thereby determining the temperature deviation characteristic value of the secondary battery.

Exemplarily, the heat capacity value, the thermal resistance value, the actual operating temperature value, and the ambient temperature value of the secondary battery are extracted from the operating state parameters. The temperature deviation characteristic value is calculated through an eighth preset expression based on the heat capacity value, the thermal resistance value, the actual operating temperature value, and the ambient temperature value. The eighth preset expression is as follows:

$$C_{th}\frac{dT}{dt} = I^2 R_0 + \sum_{k=1}^{2} \frac{\dot{U}_k^2}{R_k} - \frac{T - T_{amb}}{R_{th}} \qquad (8)$$

Where $C_{th}$ represents the heat capacity value of the secondary battery, $R_{th}$ represents the thermal resistance value of the secondary battery, $T$ represents the actual operating temperature value, $T_{amb}$ represents the ambient temperature value, $\dot{U}_1$ represents the concentration polarization voltage characteristic value, $\dot{U}_2$ represents the diffusion polarization voltage characteristic value, and $R_0$ represents the ohmic resistance value. In an embodiment, the temperature deviation characteristic value may be calculated based on the temperature change rate $\frac{dT}{dt}$ and a reference temperature change rate. As such, the deviation degree of any operating state parameter from the reference operating state parameter can be accurately and comprehensively estimated through the thermodynamic model, thereby providing a more reliable basis for the energy storage cloud to perform the fracture detection for the connection component, and laying the foundation for improving the detection effect of the fracture detection for the connection component of the energy storage system.

In an embodiment, the parameter deviation characteristic value includes the voltage deviation characteristic value and the temperature deviation characteristic value, and the preset deviation characteristic value threshold includes a preset voltage deviation characteristic value threshold and a preset temperature deviation characteristic value threshold. Performing the fracture detection for the connection component to obtain the cloud-side fracture detection result based on the magnitude relationship between the parameter deviation characteristic value and the preset deviation characteristic value threshold includes: extracting the actual operating voltage value of each secondary battery from the operating state parameters; obtaining a voltage relative deviation value by fusing the actual operating voltage value and the voltage deviation characteristic value, and obtaining a temperature relative deviation value by fusing the actual operating temperature value and the temperature deviation characteristic value; determining a magnitude relationship between the voltage relative deviation value and the preset voltage deviation characteristic value threshold, and determining a magnitude relationship between the temperature relative deviation value and the preset temperature deviation characteristic value threshold; generating the cloud-side fracture detection result according to the voltage deviation characteristic value and the temperature deviation characteristic value, in a case where the voltage relative deviation value is greater than the preset voltage deviation characteristic value threshold, and the temperature relative deviation value is less than the preset temperature deviation characteristic value threshold; using second preset component state information as the cloud-side fracture detection result, in a case where the voltage relative deviation value is less than or equal to the preset voltage deviation characteristic value threshold, and/or the temperature relative deviation value is greater than or equal to the preset temperature deviation characteristic value threshold. The second preset component state information presents that the energy storage cloud determines that the connection component is in a normal operating state.

As for performing the fracture detection for the connection component through multiple parameters including the first parameter deviation characteristic value and the second parameter deviation characteristic value, a specific determination condition can be set, so that the cloud-side fracture detection result is determined based on the determination condition.

Exemplarily, the actual operating voltage value of each secondary battery is extracted from the operating state parameters. The voltage relative deviation value is calculated through a ninth preset expression based on the actual operating voltage value and the voltage deviation characteristic value. The ninth preset expression is as follows:

$$\delta u = \left| \frac{u_i - u_i^{pre}}{u_i} \right|$$

where $\delta u$ represents the voltage relative deviation value, $u_i^{pre}$ represents the voltage deviation characteristic value, and $u_i$ represents the actual operating voltage value.

The temperature relative deviation value is calculated through a tenth preset expression based on the actual operating temperature value and the temperature deviation characteristic value. The tenth preset expression is specifically as follows:

$$\delta t = \left| \frac{t_i - t_i^{pre}}{t_i} \right|$$

where, $\delta t$ represents the temperature relative deviation value, $t_i^{pre}$ represents the temperature deviation characteristic value, and $t_i$ represents the actual operating temperature value.

The magnitude relationship between the voltage relative deviation value and the preset voltage deviation characteristic value threshold is determined, and the magnitude relationship between the temperature relative deviation value and the preset temperature deviation characteristic value threshold is determined. The cloud-side fracture detection result is generated according to the voltage deviation characteristic value and the temperature deviation characteristic value in a case where the voltage relative deviation value is greater than the preset voltage deviation characteristic value threshold and the temperature relative deviation value is less than the preset temperature deviation characteristic value threshold. The preset voltage deviation characteristic value threshold may specifically be $3\sigma_u$, and $\sigma_u$ represents a voltage residual threshold. The preset voltage deviation characteristic value threshold may specifically be in a range $[0.05V, 0.1V]$, that is, the preset voltage deviation characteristic value threshold may be any specific value within the range $[0.05V, 0.1V]$. The preset temperature deviation characteristic value threshold may specifically be $\sigma_t$, and $\sigma_t$ represents a temperature residual threshold. The preset temperature deviation characteristic value threshold may specifically be is a range $[2°C, 3°C]$, that is, the preset temperature deviation characteristic value threshold may be any specific value within the range $[2°C, 3°C]$. The second preset component state information is used as the cloud-side fracture detection result in a case where the voltage relative deviation value is less than or equal to the preset voltage deviation characteristic value threshold and/or the temperature relative deviation value is greater than or equal to the preset temperature deviation characteristic value threshold. The second preset component state information presents that the energy storage cloud determines that the connection component is in the normal operating state.

In an embodiment, generating the cloud-side fracture detection result according to the voltage deviation characteristic value and the temperature deviation characteristic value includes: determining an average voltage deviation characteristic value of the at least one secondary battery according to voltage deviation characteristic values; selecting a boundary secondary battery from the secondary batteries, and extracting a first actual operating voltage value of the boundary secondary battery and a second actual operating voltage value of a reference secondary battery adjacent to the boundary secondary battery; obtaining a voltage deviation correlation characteristic value between the boundary secondary battery and the reference secondary battery thereof by fusing the average voltage deviation characteristic value, the first actual operating voltage value, and the second actual operating voltage value; generating the cloud-side fracture detection result that the connection component is in an abnormal operating state when it is determined that the first actual operating voltage value is less than a preset actual operating voltage value threshold and the voltage deviation correlation characteristic value is less than a preset correlation characteristic value threshold.

Exemplarily, an averaging processing is performed on the voltage deviation characteristic values to obtain the average voltage deviation characteristic value of the secondary batteries. The boundary secondary battery is selected from the secondary batteries, and the first actual operating voltage value of the boundary secondary battery and the second actual operating voltage value of the reference secondary battery adjacent to the boundary secondary battery are extracted. The voltage deviation correlation characteristic value between the boundary secondary battery and the reference secondary battery is calculated through an eleventh preset expression. The eleventh preset expression is as follows:

$$u' = \left| u_{13*i} + u_{13*(i-1)} - 2\hat{u} \right| \qquad (11)$$

where u' represents the voltage deviation correlation characteristic value, $u_{13*i}$ represents the first actual operating voltage value of the boundary secondary battery, $u_{13*(i-1)}$ represents the second actual operating voltage value of the reference secondary battery, and $\hat{u}$ represents the average voltage deviation characteristic value.

The cloud-side fracture detection result that the connection component is in an abnormal operating state is generated according to the voltage deviation characteristic value and the temperature deviation characteristic value when it is determined that the first actual operating voltage value is less than the preset actual operating voltage value threshold and the voltage deviation correlation characteristic value is less than the preset correlation characteristic value threshold.

The preset actual operating voltage value threshold may specifically be 0.3v, that is, $u_{13*i} < 0.3$, $i = 0 - \frac{n}{13}$, and the preset correlation characteristic value threshold can be represented as $u_a$, which may be specifically interpreted as a voltage difference threshold. For example, in an implementable embodiment, in a case where the energy storage battery modules are in multiple series-parallel connections, the preset correlation characteristic value threshold may be in a range [0.03V, 0.1V], that is, the preset correlation characteristic value threshold may be any specific value within the range [0.03V, 0.1V].

In an embodiment, for the temperature deviation characteristic value, the determination conditions for determining temperature sampling fracture are as follows:

$$\delta t = \left| \frac{t_i - t_i^{pre}}{t_i} \right| > 3\sigma_t, \qquad \left| \frac{u_i - u_i^{pre}}{u_i} \right| < \sigma_u, \qquad and \ t_i - \hat{t} < T_a$$

Where $\delta t$ represents the temperature relative deviation value, $t_i^{pre}$ represents the temperature deviation characteristic value, $t_i$ represents the actual operating temperature value, $\hat{t}$ represents the average temperature value, $T_a$ represents the preset temperature deviation characteristic value threshold, $\sigma_t$ represents a temperature residual threshold. The preset temperature deviation characteristic value threshold is in a range [2°C, 3°C], that is, the preset temperature deviation characteristic value threshold may be any specific value within the range [2°C, 3°C].

Although the steps in the flowcharts involved in the embodiments described above are shown sequentially as indicated by arrows, the steps are not necessarily executed sequentially in the order indicated by the arrows. Unless explicitly stated herein, there is no strict order in which these steps are executed, and the steps may be performed in any other order. Furthermore, at least part of the steps of the flowcharts involved in each embodiment above may include more than one step or stage, and these steps or stages are not necessarily executed at the same time, but may be executed at different times. The order of execution of these steps or stages is not necessarily in sequence. Rather, it may be performed alternately or in turn with other steps, or at least part of the steps or stages of other steps.

Based on the same inventive concept, an embodiment of the present disclosure further provides a fracture detection device for a connection component of an energy storage system carrying out the above fracture detection methods for the connection component of the energy storage system. The technical solutions provided by the devices to address the technical problem is similar to the technical solutions recorded in the above methods, therefore specific limitations in one or more embodiments of the fracture detection device for the connection component of the energy storage system provided below may be referred to the above limitations of the fracture detection method for the connection component of the energy storage system hereinbefore, which will not be repeated herein.

In an embodiment, as shown in FIG. 3, the fracture detection device for the connection component of the energy storage system is provided, and applied to the energy storage edge. The connection component includes a conductive part and a sampling part. The conductive part is electrically connected to at least one secondary battery. The fracture detection device for the connection component of the energy storage system includes a first acquiring module 401, a determining module 402, a first detecting module 403, and a sending module 404.

The first acquiring module 401 is configured to obtain the operating state parameters of at least one secondary battery sampled and uploaded by the sampling part.

The determining module 402 is configured to determine a parameter discrete characteristic value of the operating state parameters. The parameter discrete characteristic values characterize a degree of dispersion of the operating state parameters of the at least one secondary battery.

The first detecting module 403 is configured to perform the fracture detection for the connection component according to the magnitude relationship between the parameter discrete characteristic value and the preset discrete characteristic value threshold to obtain the edge-side fracture detection result.

The sending module 404 is configured to send the operating state parameters and the edge-side fracture detection result to the energy storage cloud for the energy storage cloud to generate a fracture detection result of the connection component according to the cloud-side fracture detection result and the edge-side fracture detection result, and the cloud-side fracture detection result is predicted based on the operating state parameters.

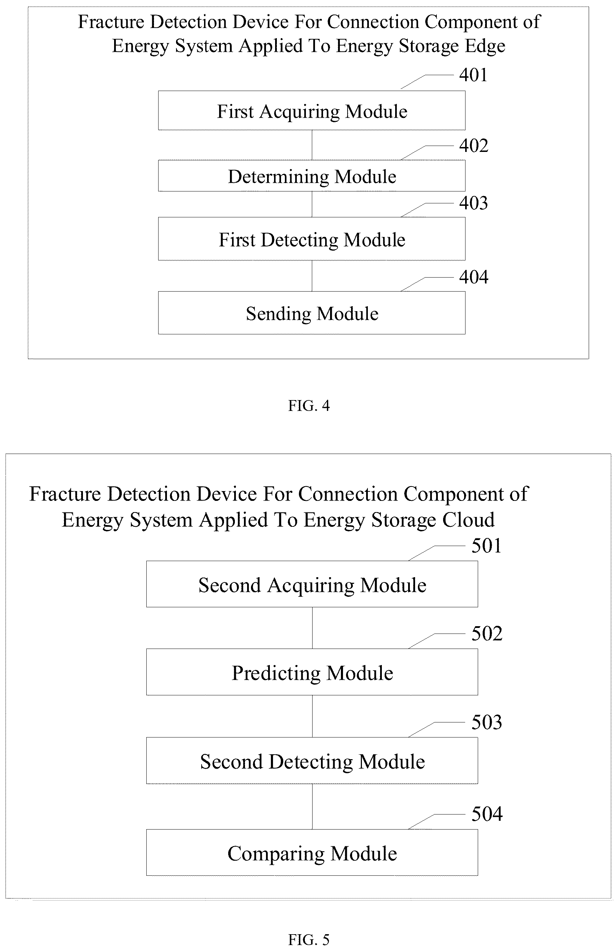

In an embodiment, as shown in FIG. 4, the fracture detection device for the connection component of the energy storage system is provided, and is applied to the energy storage cloud. The connection component includes a conductive part and a sampling part. The conductive part is electrically connected to at least one secondary battery. The fracture detection device for the connection component of the energy storage system includes a second acquiring module 501, a predicting module 502, a second detecting module 503, and a comparing module 504.

The second acquiring module 501 is configured to obtain the edge-side fracture detection result sent by the energy storage edge and the operating state parameters of at least one secondary battery sampled and uploaded by a sampling part, and the edge-side fracture detection result is obtained based on the operating state parameters.

The predicting module 502 is configured to predict the parameter deviation characteristic values of the respective secondary batteries according to the operating state parameters. The parameter deviation characteristic values characterize the deviation degrees of the operating state parameters of any secondary battery relative to the reference operating state parameters.

The second detecting module 503 is configured to perform the fracture detection for the connection component based on the magnitude relationship between the parameter deviation characteristic value and a preset deviation characteristic value threshold to obtain the cloud-side fracture detection result.

The comparing module 504 is configured to obtain the fracture detection result of the connection component by comparing the edge-side fracture detection result and the cloud-side fracture detection result.

All or part of the modules in the above fracture detection device for the connection component of the energy storage system can be implemented through software, hardware, or a combination thereof. The above modules can be embedded in or independent of the processor in a computer device in forms of hardware, or stored in a memory of the computer device in forms of software, so that the processor can call and execute corresponding operations of the modules.

In an embodiment, an energy storage system is provided. The energy storage system includes a management and control terminal of the energy storage system. The internal structure of the management and control terminal of the energy storage system is shown in FIG. 5. The management and control terminal of the energy storage system includes a processor, a memory, an input/output interface, a communication interface, a display unit, and an input device. The processor, memory, and input/output interface are connected through a system bus. The communication interface, the display unit, and the input device are connected to the system bus through the input/output interface. The processor of the management and control terminal of the energy storage system is configured to provide abilities of calculation and control. The management and control terminal of the energy storage system includes a non-transitory storage medium and an internal memory. The non-transitory memory stores an operating system and a computer program thereon. The internal memory provides an environment for operation of the operating system and computer program in the non-transitory storage medium. The input/output interface of the management and control terminal of the energy storage system is configured to exchange information between the processor and an external device. The communication interface of the management and control terminal is configured to communicate with an external terminal by wired or wireless means, which may be realized by Wireless Fidelity (WIFI), Mobile Cellular Network (MCN), near field communication (NFC) or other techniques. The fracture detection method for the connection component of the energy storage system is implemented when the computer program is executed by the processor. A person skilled in the art can understand that the structure shown in FIG. 5 is merely a block diagram of a partial structure related to the technical solution of the present disclosure, and does not constitute a limitation on the management and control terminal of the energy storage system to which the technical solution of the present disclosure is applied. The management and control terminal of the energy storage system may include more or fewer components than those shown in the drawings, a combination of some components, or an arrangement having different components.

A person skilled in the art can understand that all or part of the processes in the methods in the embodiments above can be accomplished by instructing relevant hardware through the computer program. The computer program can be stored in the non-transitory computer-readable storage medium. When executed, the computer program can include procedures in the embodiments of the above methods. Any reference to the memory, a database, or other medium provided in the embodiments of the present disclosure can include at least one of non-transitory memory or transitory memory. The non-transitory memory can include a read-only memory (ROM), a magnetic tape, a floppy disk, a flash memory, an optical memory, a high-density embedded non-transitory memory, a resistive random-access memory (ReRAM), a magneto resistive random-access memory (MRAM), a ferroelectric random-access memory (FRAM), a phase change memory (PCM), a graphene memory, etc. The transitory memory can include a random-access memory (RAM) or an external cache memory. As an illustration rather than a limitation, the RAM may be in various forms, such as a Static Random Access Memory (SRAM) or a Dynamic Random Access Memory (DRAM). The database involved in embodiments provided in the present disclosure can include at least one of a relational database or a non-relational database. The non-relational database can include a distributed database based on blockchain, and the specific form of the non-relational database is not limited herein. The processor involved in the embodiments provided in the present disclosure may be a general-purpose processor, a central processing unit, a graphics processing unit, a digital signal processor, a programmable logic device, or a data processing logic device based on quantum computing, etc., which is not limited herein.

**Claims**

1. A fracture detection method for a connection component of an energy storage system, applied to an energy storage edge, wherein the connection component comprises a conductive part and a sampling part; the conductive part is electrically connected to at least one secondary battery; and the fracture detection method for the connection component of the energy storage system comprises:

obtaining operating state parameters of the at least one secondary battery sampled and uploaded by the sampling part;

determining a parameter discrete characteristic value of the operating state parameters, the parameter discrete characteristic value characterizing a degree of dispersion of the operating state parameters of the at least one secondary battery;

performing a fracture detection for the connection component according to a magnitude relationship between the parameter discrete characteristic value and a preset discrete characteristic value threshold to obtain an edge-side fracture detection result; and

sending the operating state parameters and the edge-side fracture detection result to an energy storage cloud for the energy storage cloud to generate a fracture detection result of the connection component according to a cloud-side fracture detection result and the edge-side fracture detection result, and the cloud-side fracture detection result being predicted based on the operating state parameters.

2. The fracture detection method for the connection component of the energy storage system according to claim 1, wherein the parameter discrete characteristic value comprises a first parameter discrete characteristic value; and determining the parameter discrete characteristic value of the operating state parameters comprises:

determining a first parameter characteristic value corresponding to the operating state parameters, determining a second parameter characteristic value corresponding to the operating state parameters, and the first parameter characteristic value and the second parameter characteristic values being parameter characteristic values of different dimensions; and

obtaining the first parameter discrete characteristic value by fusing the first parameter characteristic value and the second parameter characteristic value.

3. The fracture detection method for the connection component of the energy storage system according to claim 1 or 2, wherein the parameter discrete characteristic value comprises a second parameter discrete characteristic value; and determining the parameter discrete characteristic value of the operating state parameters comprises:

selecting an operating state characteristic parameter from the operating state parameters based on magnitudes of the operating state parameters; and

obtaining the second parameter discrete characteristic value by fusing each of the operating state parameters and the operating state characteristic parameter.

4. The fracture detection method for the connection component of the energy storage system according to any one of claims 1 to 3, wherein the parameter discrete characteristic value comprise a first parameter discrete characteristic value and a second parameter discrete characteristic value, and the preset discrete characteristic value threshold comprises a first preset discrete characteristic value threshold and a second preset discrete characteristic value threshold; and performing the fracture detection for the connection component according to the magnitude relationship between the parameter discrete characteristic value and the preset discrete characteristic value threshold to obtain the edge-side fracture detection result comprises:

determining a magnitude relationship between the first parameter discrete characteristic value and the first preset discrete characteristic value threshold, and determining a magnitude relationship between the second parameter discrete characteristic value and the second preset discrete characteristic value threshold;

generating the edge-side fracture detection result according to the first parameter discrete characteristic value and the second parameter discrete characteristic value in response to a determination that the first parameter discrete characteristic value is greater than the first preset discrete characteristic value threshold and the second parameter discrete characteristic value is greater than the second preset discrete characteristic value threshold; and

using first preset component state information as the edge-side fracture detection result in response to a determination that the first parameter discrete characteristic value is less than or equal to the first preset discrete characteristic value threshold or the second parameter discrete characteristic value is less than or equal to the second preset discrete characteristic value threshold, wherein the first preset component state information represents that the energy storage edge determines that the connection component is in a normal operating state; optionally, wherein the first preset discrete characteristic value threshold is in a range [0.02V, 0.05V]; optionally, wherein the second preset discrete characteristic value threshold is in a range [3°C, 5°C].

5. The fracture detection method for the connection component of the energy storage system according to claim 4, wherein the first parameter discrete characteristic value is a voltage discrete characteristic value, and the second parameter discrete characteristic value is a temperature discrete characteristic value; and generating the edge-side fracture detection result according to the first parameter discrete characteristic value and the second parameter discrete characteristic value comprises:

selecting a first target secondary battery with abnormal voltage from the secondary batteries according to an operating state parameter corresponding to the voltage discrete characteristic value, and selecting a second target secondary battery with abnormal temperature from the secondary batteries according to an operating state parameter corresponding to the temperature discrete characteristic value;

locating at least one first abnormal point with abnormal voltage on the connection component according to a connection relationship between the first target secondary battery and the connection component;

locating at least one second abnormal point with abnormal temperature on the connection component according to a heat conduction path of the second target secondary battery;

obtaining a target abnormal point on the connection component by fusing each first abnormal point and each second abnormal point; and

generating the edge-side fracture detection result according to first position information of the target abnormal point;

optionally, wherein locating the at least one second abnormal point with abnormal temperature on the connection component according to the heat conduction path of the second target secondary battery comprises: constructing a heat conduction path model of the second target secondary battery according to the heat conduction path of the second target secondary battery, and predicting the second abnormal point of the second target secondary battery through the heat conduction path model.

6. The fracture detection method for the connection component of the energy storage system according to claim 5, wherein obtaining the target abnormal point on the connection component by fusing each first abnormal point and second abnormal point comprises:

determining at least one candidate abnormal point in an intersection of the at least one first abnormal point and the at least one second abnormal point;

prioritizing the at least one candidate abnormal point according to second position information of the at least one candidate abnormal point to obtain a prioritization result; and

selecting the target abnormal point from the at least one candidate abnormal point according to the prioritization result.

7. The fracture detection method for the connection component of the energy storage system according to claim 6, wherein prioritizing the at least one candidate abnormal point according to the second position information of the at least one candidate abnormal point to obtain the prioritization result comprises:

determining a voltage abnormality characteristic value and a temperature abnormality characteristic value of each candidate abnormal point according to the second position information of each candidate abnormal point;

determining a voltage abnormality weight value and a temperature abnormality weight value of each candidate abnormal point;

fusing the voltage abnormality characteristic value and the temperature abnormality characteristic value based on the voltage abnormality weight value and the temperature abnormality weight value to obtain a comprehensive abnormality characteristic value of each candidate abnormal point; and

prioritizing the at least one candidate abnormal point according to respective comprehensive abnormality characteristic value of the at least one candidate abnormal point to obtain the prioritization result.

8. A fracture detection method for a connection component of an energy storage system, applied to an energy storage cloud, wherein the connection component comprises a conductive part and a sampling part; the conductive part is electrically connected to at least one secondary battery; and the fracture detection method for the connection component of the energy storage system comprises:

receiving the edge-side fracture detection result and the operating state parameters sent according to the fracture detection method for the connection component of the energy storage system of any one of claims 1 to 7;

predicting a parameter deviation characteristic value of each secondary battery according to the operating state parameters, and the parameter deviation characteristic value characterizing a deviation degree of the operating state parameters of each secondary battery relative to reference operating state parameters;

performing a fracture detection for the connection component based on a magnitude relationship between the parameter deviation characteristic value and a preset deviation characteristic value threshold to obtain a cloud-side fracture detection result; and

obtaining a fracture detection result of the connection component by comparing the edge-side fracture detection result and the cloud-side fracture detection result.

9. The fracture detection method for the connection component of the energy storage system according to claim 8, wherein the parameter deviation characteristic value comprises a voltage deviation characteristic value; and predicting the parameter deviation characteristic value of each secondary battery according to the operating state parameters comprises:

extracting a concentration polarization voltage value, a diffusion polarization voltage value, a concentration polarization resistance value, an ohmic resistance value, a diffusion polarization resistance value, a concentration polarization capacitance value, a diffusion polarization capacitance value, and an actual operating current value of each secondary battery from the operating state parameters;
predicting a concentration polarization voltage characteristic value of each secondary battery according to the concentration polarization voltage value, the concentration polarization resistance value, the concentration polarization capacitance value, and the actual operating current value; predicting a diffusion polarization voltage characteristic value of each secondary battery according to the diffusion polarization voltage value, the diffusion polarization resistance value, the diffusion polarization capacitance value, and the actual operating current value; the concentration polarization voltage characteristic value characterizing a variation of the concentration polarization voltage value with the actual operating current value, and the diffusion polarization voltage characteristic value characterizing a variation of the diffusion polarization voltage value with the actual operating current value; and
fusing the concentration polarization voltage characteristic value, the diffusion polarization voltage characteristic value, the ohmic resistance value, and the actual operating current value to obtain the voltage deviation characteristic value of each secondary battery.

10. The fracture detection method for the connection component of the energy storage system according to claim 8 or 9, wherein the parameter deviation characteristic value comprises a temperature deviation characteristic value; and predicting the parameter deviation characteristic value of each secondary battery according to the operating state parameters comprises:

extracting a heat capacity value, a thermal resistance value, an actual operating temperature value, and an ambient temperature value of each secondary battery from the operating state parameters; and
predicting the temperature deviation characteristic value of each secondary battery based on the heat capacity value, the thermal resistance value, the actual operating temperature value, and the ambient temperature value.

11. The fracture detection method for the connection component of the energy storage system according to any one of claims 8 to 10, wherein the parameter deviation characteristic value comprises a voltage deviation characteristic value and a temperature deviation characteristic value, and the preset deviation characteristic value threshold comprises a preset voltage deviation characteristic value threshold and a preset temperature deviation characteristic value threshold; performing the fracture detection for the connection component based on a magnitude relationship between the parameter deviation characteristic value and the preset deviation characteristic value threshold to obtain the cloud-side fracture detection result comprises:

extracting the actual operating voltage value of each secondary battery from the operating state parameters;
obtaining a voltage relative deviation value by fusing the actual operating voltage value and the voltage deviation characteristic value, and obtaining a temperature relative deviation value by fusing the actual operating temperature value and the temperature deviation characteristic value;
determining a magnitude relationship between the voltage relative deviation value and the preset voltage deviation characteristic value threshold, and determining a magnitude relationship between the temperature relative deviation value and the preset temperature deviation characteristic value threshold;
generating the cloud-side fracture detection result according to the voltage deviation characteristic value and the temperature deviation characteristic value in response to a determination that the voltage relative deviation value is greater than the preset voltage deviation characteristic value threshold and the temperature relative deviation value is less than the preset temperature deviation characteristic value threshold; and
using second preset component state information as the cloud-side fracture detection result in response to a determination that the voltage relative deviation value is less than or equal to the preset voltage deviation characteristic value threshold or the temperature relative deviation value is greater than or equal to the preset temperature deviation characteristic value threshold; and the second preset component state information characterizing that the energy storage cloud determines that the connection component is in a normal operating state.

12. The fracture detection method for the connection component of the energy storage system according to claim 11, wherein the generating the cloud-side fracture detection result according to the voltage deviation characteristic value and the temperature deviation characteristic value comprises:

determining an average voltage deviation characteristic value of the at least one secondary battery according to voltage deviation characteristic values;

selecting a boundary secondary battery from the at least one secondary battery, and extracting a first actual operating voltage value of the boundary secondary battery and a second actual operating voltage value of a reference secondary battery adjacent to the boundary secondary battery;

obtaining a voltage deviation correlation characteristic value between the boundary secondary battery and the reference secondary battery by fusing the average voltage deviation characteristic value, the first actual operating voltage value, and the second actual operating voltage value; and

generating the cloud-side fracture detection result that the connection component is in an abnormal operating state in response to a determination that the first actual operating voltage value is less than a preset actual operating voltage value threshold and the voltage deviation correlation characteristic value is less than a preset correlation characteristic value threshold.

13. An energy storage system, comprising a memory and a processor, the memory has a computer program stored thereon, wherein the processor, when executing the computer program, implements the fracture detection method for the connection component of the energy storage system according to any one of claims 1 to 12.

14. A computer-readable storage medium, having a computer program stored thereon, wherein the computer program, when executed by a processor, causes the processor to implement the fracture detection method for the connection component of the energy storage system according to any one of claims 1 to 12.

15. A computer program product, comprising a computer program, wherein the computer program, when executed by a processor, causes the processor to perform the fracture detection method for the connection component of the energy storage system according to any one of claims 1 to 12.

The operating state parameters of at least one secondary battery sampled and uploaded by the sampling part are obtained. — 202

A parameter discrete characteristic value of the operating state parameters is determined, and the parameter discrete characteristic value characterizes a degree of dispersion of the operating state parameters of the at least one secondary battery. — 204

The fracture detection for the connection component is performed according to the magnitude relationship between the parameter discrete characteristic value and the preset discrete characteristic value threshold, to obtain the edge-side fracture detection result. — 206

The operating state parameters and the edge-side fracture detection result are sent to the energy storage cloud for the energy storage cloud to generate a fracture detection result of the connection component according to the cloud-side fracture detection result and the edge-side fracture detection result, and the cloud-side fracture detection result is predicted based on the operating state parameters. — 208

FIG. 1

The edge-side fracture detection result sent by the energy storage edge and the operating state parameters of at least one secondary battery sampled and uploaded by a sampling part are obtained, and the edge-side fracture detection result is obtained based on the operating state parameters. — 302

A parameter deviation characteristic value of each secondary battery is predicted according to the operating state parameters, and the parameter deviation characteristic value characterizes a deviation degree of the operating state parameters of the secondary battery relative to reference operating state parameters. — 304

The fracture detection for the connection component is performed based on the magnitude relationship between the parameter deviation characteristic value and a preset deviation characteristic value threshold to obtain the cloud-side fracture detection result. — 306

The fracture detection result of the connection component is obtained by comparing the edge-side fracture detection result and the cloud-side fracture detection result. — 308

FIG. 2

Start

the energy storage edge
detects whether the
connection component
has a fracture
abnormality

NO

YES

the energy storage cloud
detects whether the
connection component
has a fracture
abnormality

NO

YES

The connection
component has no
fracture abnormality.

The connection
component has a
fracture abnormality.

FIG. 3

Fracture Detection Device For Connection Component of
Energy System Applied To Energy Storage Edge

— 401

First Acquiring Module

— 402

Determining Module

— 403

First Detecting Module

— 404

Sending Module

FIG. 4

Fracture Detection Device For Connection Component of
Energy System Applied To Energy Storage Cloud

— 501

Second Acquiring Module

— 502

Predicting Module

— 503

Second Detecting Module

— 504

Comparing Module

FIG. 5

Memory

| Processor | | Internal Memory | | Operating System |
| | | | | Computer Program |
| | | | | Non-transitory Storage Medium |

System Bus

Input/Output Interface

| Input Device | | Communication Interface | | Display Unit |

Energy Storage System

FIG. 6